# EUROPEAN PATENT APPLICATION

(11) **EP 4 848 924 A1**
(43) Date of publication of application: **02.12.2026**
(21) Application number: 26175393.3
(22) Date of filing: 29.04.2026
(51) Int. Cl.: H10B 12/00, H10B 41/10, H10B 41/50, H10B 43/10, H10B 43/50

(54) **BLOCKING STRUCTURE TO PREVENT CONTACT SHORTS IN MEMORY CIRCUITS**

(30) Priority: 28.05.2025 US 202563813603 P; 25.03.2026 US 202619578857
(71) Applicant: Samsung Electronics Co., Ltd., Suwon-si, Gyeonggi-do 16677 (KR)
(72) Inventor: NOSHIN, Maliha, San Jose, CA, 95134 (US); KIM, Dongwan, San Jose, CA, 95134 (US); JEONG, Young Doo Kevin, San Jose, CA, 95134 (US); KIM, Taehwa, San Jose, CA, 95134 (US)
(74) Representative: Kuhnen & Wacker Patent- und Rechtsanwaltsbüro PartG mbB

(57) **Abstract**

A system and a method for a blocking structure to prevent contact shorts are disclosed. The blocking structure includes a first blocking member, a second blocking member, and a third blocking member. The first blocking member is positioned between a first contact having a first side, a second side, and a third side, and a second contact along a first direction in a first region on the first side. The first contact and the second contact contact word lines (WLs) in a pad area of a three-dimensional memory device. The second blocking member is connected to the first blocking member along a second direction and positioned in a second region on the second side. The third blocking member is connected to the first blocking member along a third direction and positioned in a third region on the third side. The first blocking member, the second blocking member, and the third blocking member form a structure that extends around the first side, the second side, and the third side.

## Description

### TECHNICAL FIELD

The disclosure generally relates to memory circuits. More particularly, the subject matter disclosed herein relates to a blocking structure to prevent contact shorts in three-dimensional (3D) memory devices.

### BACKGROUND

The present background section is intended to provide context only, and the disclosure of any concept in this section does not constitute an admission that said concept is prior art.

Three-dimensional (3D) memory configurations have been increasingly popular. 3D memory devices, such as vertically stacked dynamic random-access memory (VSDRAM), include memory cells that are stacked vertically to increase storage density. The additional vertical direction poses considerations in arranging the memory cells in the 2D plane to accommodate the desired density. Staircase-free structures eliminate the staircase designs that provide connections to word lines (WL).

Etching in high aspect ratio memory circuits may cause the contact pillars to bow or skew. This cause risks of shorting between contacts to contacts or contacts to word lines (WL).

The above information disclosed in this Background section is only for enhancement of understanding of the background of the disclosure and therefore it may contain information that does not constitute prior art.

### SUMMARY

To overcome these issues, systems and methods are described herein for a blocking structure that prevents contact shorts in a 3D memory device. The blocking structure includes a first blocking member, a second blocking member, and a third blocking member. The first blocking member is positioned between a first contact having first, second, and third sides, and a second contact along a first direction in a first region on the first side. The first contact and the second contact contacts word lines (WLs) in a pad area of a three-dimensional memory circuit. The second blocking member is connected to the first blocking member along a second direction and positioned in a second region on the second side. The third blocking member is connected to the first blocking member along a third direction and positioned in a third region on the third side. The first, second, and third blocking members extend around or alongside the first, second, and third sides, respectively. The blocking structure blocks an etching process.

In some embodiments, the blocking structure further includes a fourth blocking member which is connected to the second and third blocking members and positioned in a fourth region on a fourth side of the first contact. The first, second, third, and fourth blocking members form a structure that encloses the first contact. In some embodiments, at least one of the first, second, third, and fourth blocking members includes a material that blocks an etching process to prevent contact shorting. The material includes a nitride including at least one of silicon nitride (Si₃N₄), gallium nitride (GaN), aluminum gallium nitride (AlGaN), hexagonal boron nitride (h-BN), or aluminum nitride (AIN).

In some embodiments, a process of forming a block structure includes forming a first part in a first module of a three-dimensional (3D) base structure, forming a second part in a second module along the first module, forming inter-tier dielectric (ITD) word lines (WL) in the second module, and forming contacts within the blocking structure.

### BRIEF DESCRIPTION OF THE DRAWINGS

In the following section, the aspects of the subject matter disclosed herein will be described with reference to exemplary embodiments illustrated in the figures, in which:
FIG. 1 is a block diagram illustrating a system that utilizes a 3D memory circuit having a blocking structure according to an embodiment.
FIG. 2 is a diagram illustrating a 3D memory circuit that utilizes a blocking structure to prevent contact shorting during an etching process according to an embodiment.
FIG. 3 is a diagram illustrating top views of the blocking structure at various depth levels according to an embodiment.
FIG. 4 is a diagram illustrating dimensions and geometrical properties of some elements in the memory circuit according to an embodiment.
FIG. 5 is a diagram illustrating a process that forms the blocking structure according to an embodiment.
FIG. 6 is a diagram illustrating a process of forming a first part of the blocking structure according to an embodiment.
FIG. 7 is a diagram illustrating a process of forming a second part of the blocking structure according to an embodiment.
FIG. 8 is a diagram illustrating a process of forming inter-tier dielectric word lines according to an embodiment.
FIG. 9A is a diagram illustrating a first part of a process of forming contacts according to an embodiment.
FIG. 9B is a diagram illustrating a second part of a process of forming contacts according to an embodiment.
FIG. 10 is a diagram illustrating a 3D structure of the process of forming the blocking structure according to an embodiment.
FIG. 11 is a diagram illustrating a 3D structure of a partial process of forming the contacts according to an embodiment.
FIG. 12 is a diagram illustrating a 3D structure of a final process of forming the contacts according to an embodiment.
FIG. 13 is a flowchart illustrating a process of forming a blocking structure that prevents contact shorts according to an embodiment.
FIG. 14 is a flowchart illustrating a process of forming a first part of the blocking structure that prevents contact shorts according to an embodiment.
FIG. 15 is a flowchart illustrating a process of forming a second part of the blocking structure that prevents contact shorts according to an embodiment.
FIG. 16 is a flowchart illustrating a process of forming inter-tier dielectric word lines according to an embodiment.
FIG. 17 is a flowchart illustrating a process of forming contacts within the blocking structure according to an embodiment.

### DETAILED DESCRIPTION

In the following detailed description, numerous specific details are set forth in order to provide a thorough understanding of the disclosure. It will be understood, however, by those skilled in the art that the disclosed aspects may be practiced without these specific details. In other instances, well-known methods, procedures, components and circuits have not been described in detail to not obscure the subject matter disclosed herein.

Reference throughout this specification to "one embodiment" or "an embodiment" means that a particular feature, structure, or characteristic described in connection with the embodiment may be included in at least one embodiment disclosed herein. Thus, the appearances of the phrases "in one embodiment" or "in an embodiment" or "according to one embodiment" (or other phrases having similar import) in various places throughout this specification may not necessarily all be referring to the same embodiment. Furthermore, the particular features, structures or characteristics may be combined in any suitable manner in one or more embodiments. In this regard, as used herein, the word "exemplary" means "serving as an example, instance, or illustration." Any embodiment described herein as "exemplary" is not to be construed as necessarily preferred or advantageous over other embodiments. Additionally, the particular features, structures, or characteristics may be combined in any suitable manner in one or more embodiments.

Also, depending on the context of discussion herein, a singular term may include the corresponding plural forms and a plural term may include the corresponding singular form. Similarly, a hyphenated term (e.g., "two-dimensional," "pre-determined," "pixel-specific," etc.) may be occasionally interchangeably used with a corresponding non-hyphenated version (e.g., "two dimensional," "predetermined," "pixel specific," etc.), and a capitalized entry (e.g., "Counter Clock," "Row Select," "PIXOUT," etc.) may be interchangeably used with a corresponding non-capitalized version (e.g., "counter clock," "row select," "pixout," etc.). Such occasional interchangeable uses shall not be considered inconsistent with each other. Also, depending on the context of discussion herein, a singular term may include the corresponding plural forms and a plural term may include the corresponding singular form. It is further noted that various figures (including component diagrams) shown and discussed herein are for illustrative purpose only, and are not drawn to scale. For example, the dimensions of some of the elements may be exaggerated relative to other elements for clarity. Further, if considered appropriate, reference numerals have been repeated among the figures to indicate corresponding and/or analogous elements. In the following, figures depicting various components, structures, interconnections, configurations, and steps of fabrication, are mainly for illustrative purposes. They are not intended to describe these elements accurately. A cross-sectional representation may be used to refer to a 3D block in a 3D structure. In some cases, relevant parts in a figure are shown clearly while other parts are shown with less sharpness or clarity to avoid confusion and improve contrast and clarity. These parts may be referenced in earlier figures and therefore do not need to be described again. These parts may also have little relationship with the part(s) being described. In addition, the shading of the parts in the figures may not have a consistent design and may be changed to maintain clarity and contrast in the figures. For example, part A may have a light shading in Fig. X but may be heavily shaded in Fig. Y. Moreover, as mentioned above, components in a figure may not be drawn with proper scales.

The terminology used herein is for the purpose of describing some example embodiments only and is not intended to be limiting of the claimed subject matter. As used herein, the singular forms "a," "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof.

It will be understood that when an element or layer is referred to as being on, "connected to" or "coupled to" another element or layer, it can be directly on, connected or coupled to the other element or layer or intervening elements or layers may be present. In contrast, when an element is referred to as being "directly on," "directly connected to" or "directly coupled to" another element or layer, there are no intervening elements or layers present. Like numerals refer to like elements throughout. As used herein, the term "and/or" includes any and all combinations of one or more of the associated listed items. The terms "first," "second," etc., as used herein, are used as labels for nouns that they precede, and do not imply any type of ordering (e.g., spatial, temporal, logical, etc.) unless explicitly defined as such. Furthermore, the same reference numerals may be used across two or more figures to refer to parts, components, blocks, circuits, units, or modules having the same or similar functionality. Such usage is, however, for simplicity of illustration and ease of discussion only; it does not imply that the construction or architectural details of such components or units are the same across all embodiments or such commonly-referenced parts/modules are the only way to implement some of the example embodiments disclosed herein.

Unless otherwise defined, all terms (including technical and scientific terms) used herein have the same meaning as commonly understood by one of ordinary skill in the art to which this subject matter belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

In 3D memory circuits with high aspect ratios, the fabrication of contacts in the pad area faces the risk of electrical shorts involving contacts due to the bowing or skewing of the contact pillars in vertical or depth direction. This is a result of the etching process often has a tapered profile. In the following, a system and a method for fabricating a blocking structure that prevents contact shorts. The process involves forming a number of blocking structures surrounding locations where contacts will be made. After the blocking structures are formed, the process forms contacts in the pad area and inside the individual block structures. Forming the blocking structure before etching the contacts enables an effective control means to block or stop bowing of contact pillars. That way, contact shorting is prevented.

The blocking structure includes a first blocking member, a second blocking member, and a third blocking member. The first blocking member is positioned between a first contact having first, second, and third sides, and a second contact along a first direction in a first region on the first side. The first contact and the second contact contact two different word lines (WLs) in a pad area of a three-dimensional memory circuit. The second blocking member is connected to the first blocking member along a second direction and positioned in a second region on the second side. The third blocking member is connected to the first blocking member along a third direction and positioned in a third region on the third side. The first, second, and third blocking members form a structure that extends around or alongside the first, second, and third sides, respectively. The first, second, and third blocking members block an etching process that may cause contact shorting.

In some embodiments, the blocking structure further includes a fourth blocking member which is connected to the second and third blocking members and positioned in a fourth region on a fourth side of the first contact. The first, second, third, and fourth blocking members form a structure that encloses the first contact. In some embodiments, at least one of the first, second, third, and fourth blocking members includes a material that blocks an etching process to prevent contact shorting. The material includes at least a nitride, such as silicon nitride.

In some embodiments, a process of forming a blocking structure includes forming a first part in a first module of a three-dimensional (3D) base structure, forming a second part in a second module along the first module, forming inter-tier dielectric (ITD) word lines (WL) in the second module, and forming contacts within the blocking structure. Forming the first part includes etching the 3D base structure having a pad area and an array area in the first module in a deep trench isolation (DTI) process to create an etched structure having a capping layer, depositing a first dielectric into the etched structure to form a first liner trench to fill array trenches, trimming the first liner trench in the pad area to form a trimmed liner trench, and depositing a second dielectric into the trimmed liner trench to fill pad trenches. In some embodiments, the second dielectric has higher resistance to chemical etching and higher thermal and mechanical stability than the first dielectric. The first dielectric may include an oxide including silicon oxide (SiO₂), titanium dioxide (TiO₂), and iridium oxide (IrOₓ). The second dielectric may include a nitride including silicon nitride (Si₃N₄), gallium nitride (GaN), aluminum gallium nitride (AlGaN), hexagonal boron nitride (h-BN), and aluminum nitride (AIN).

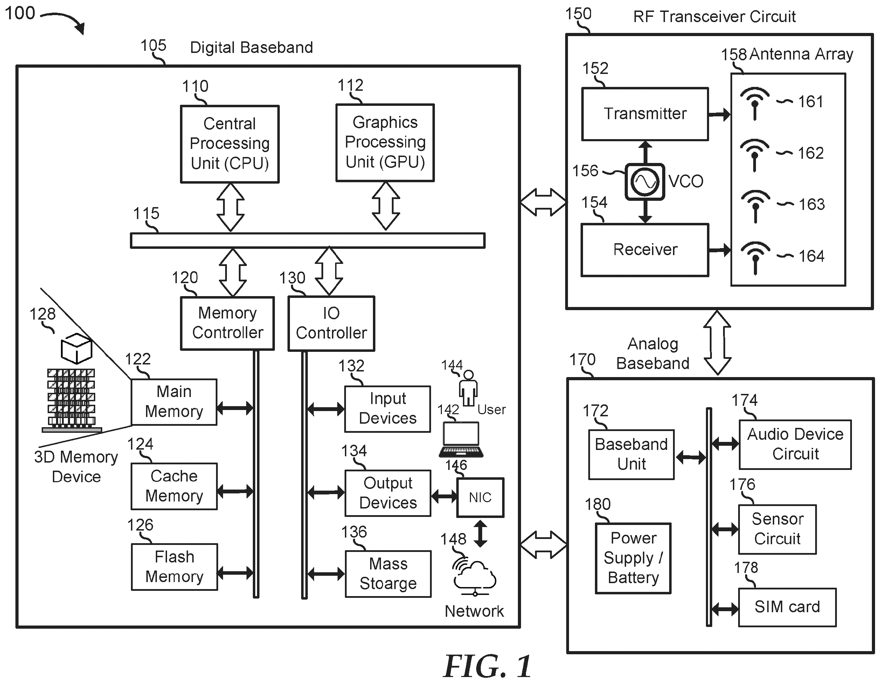

FIG. 1 is a block diagram illustrating a system that utilizes a 3D memory circuit according to an embodiment. The system 100 includes a digital baseband circuit 105, a radio frequency (RF) transceiver circuit 150, and an analog baseband circuit 170. The system 100 may represent a digital system or a mobile system. When the system 100 is used as a digital system without mobile circuitry, the RF transceiver circuit 160, and the analog baseband circuit 190 are not used. In addition, when the system 100 is used as a mobile device, many of the digital devices are scaled back and some devices may not be available.

The digital baseband circuit 105 includes central processing unit (CPU) 110, a graphics processing unit (GPU) 112, a memory controller 120, and an IO controller 130. The system 100 may include more or less than the above components. In addition, a component may be integrated into another component. The integration may be partial and/or overlapped. For example, the memory controller 120 and the I/O controller 130 may be integrated into one single controller.

The CPU 110 is a programmable device that may execute a program or a collection of instructions to carry out a task. It may be a host that controls or manages other processors or devices. In particular, the CPU 110 may include applications programming interfaces (APIs), applications, or drivers that are executed by the CPU 110 to perform specified tasks. The CPU 110 may be a general-purpose processor, a digital signal processor, a microcontroller, or a specially designed processor. It may include a single core or multiple cores. Each core may have multi-way multi-threading. The CPU 110 may have simultaneous multithreading feature to further exploit the parallelism due to multiple threads across the multiple cores. In addition, the CPU 110 may have internal caches at multiple levels.

The GPU 112 is a specialized processor designed to perform computationally intensive tasks such as image analysis, graphics rendering, and neural computations. In addition, the GPU 112 may be designed with parallel processing capability, suitable for parallel computations in artificial intelligence (AI) applications including machine learning (ML), large language model (LLM), and neural networks (NN). The GPU 112 may be used to accelerate training and running Al models. It may include multiple computational accelerators or tensor cores which are optimized for basic Al computations such as matrix multiply-accumulate operations

The CPU 110 and the GPU 112 communicate with other devices in the system via a bus 115. The bus 115 may include address, data, control, timing, and power signals. The bus 115 may be any suitable bus connecting the CPU 110 and/or the GPU 112 to other devices. For example, the bus 115 may be a Direct Media Interface (DMI). The bus 115 may also include other custom buses such as bus for the interface to the analog section when the system 100 is used as a mobile device. Additional devices or bus interfaces may be available for interconnections and/or expansion. Some examples may include the Peripheral Component Interconnect Express (PCle) bus, the Universal Serial Bus (USB), etc.

The memory controller 120 controls memory devices such as a main memory 122, a cache memory 124, and a flash memory 126. The main memory 122 includes random access memory (RAM) including static RAM (SRAM) and dynamic RAM (DRAM) and/or the read-only memory (ROM) and other types of memory. The DRAM may include Synchronous DRAM (SDRAM), Double Data Rate SDRAM (DDR SDRAM) with variations (e.g., DDR2, DDR3, DDR4, DDR5, and DDR6). The main memory 122 may store instructions or programs, loaded from a mass storage device, that, when executed by the CPU 110, cause the CPU 110 to perform operations for a specified task. It may also store data used in the operations. The ROM may be a solid-state drive (SSD) and include instructions, programs, constants, or data that are maintained whether it is powered or not. The instructions or programs may correspond to the functionalities described in the following. In one embodiment, the main memory 122 includes a 3D memory device or circuit 128 such as VSDRAM or any other memory devices that have memory cells that are stacked vertically to increase storage density. The 3D memory device 128 may have a blocking structure that blocks the bowing of contact pillars during contact etching. This blocking structure blocks or stops the binary etching and therefore prevents shorting between contacts or contacts and word lines.

The I/O controller 130 controls input devices 132, output devices 134, and mass storage 136. The input devices 132 may include a keyboard, a mouse, an image sensor or camera, a game console, and a microphone. Other input devices may also be available such as stylus, joystick, scanner, and light pen. The input devices may also have a user interface to interface to a computer or laptop 142 and/or a user 144. The output devices 134 may include a printer, a monitor or screen, a headset, and a multi-monitor set. When used as a computing device without mobile features, the monitor is a high-resolution display. For games and other multi-display mode, the multi-monitor set provides high-resolution with multiple monitors (e.g., three monitors). When used for mobile communication, the screen provides the primary interface for the user to navigate, access various applications and perform tasks. The screen may use organic light-emitting diode (OLED) (super retina) display with multi-touch or haptic touch feature. The mass storage 136 may include CD-ROM, hard disk, and solid-state drives (SSDs). The I/O controller 130 also has a network interface card (NIC) 145 which provides an interface to a network and wireless medium 148.

The RF transceiver circuit 150 includes a transmitter 152, an antenna array 158, a voltage-controlled oscillator (VCO) 156, and a receiver 154. The RF circuit 150 operates at a high GHz frequency band to accommodate modern cellular equipment such as the wireless fifth generation (5G).

The transmitter 152 transmits the digital baseband data to the antenna array 158. The transmitter 152 may include a digital-to-analog converter (DAC), an automatic gain controller (AGC), an intermediate frequency (IF) circuit, a mixer, an RF circuit, and a power amplifier (PA). Other components may include filters, amplifiers, multiplexers, coaxial cables, phase shifters, etc. The DAC converts digital data f₁ into an analog signal f₂. The AGC automatically adjusts the signal amplitude of f₂ to generate a signal f₃ to maintain a consistent strength level in a dynamic and changing environment. The IF circuit performs intermediate frequency processes such as filtering to generate a signal f₄. The mixer converts the frequency of the signal f₄ to another frequency. This is done by mixing the signal f₄ with a signal vₜ from the VCO 156. Mixing here refers to frequency modulation which translates the signal f₄ to a signal f₅ at a different frequency. For transmitter, the translated frequency is higher than the frequency of f₄. The conversion is called up-conversion. For 5G communication, the frequency range may include low-band (below 1 GHz), mid-band (1 GHz to 6 GHz), and high-band (24 GHz to 53 GHz or higher). The resulting signal f₅ then goes through various radio frequency processes performed by the RF circuit such as high-pass filtering to produce a signal f₆. The signal f₆ is strengthened and amplified by the PA to produce a signal f₇. The signal f₇ then goes to the antenna array 158 to be transmitted to an appropriate destination and medium (e.g., base station). The antenna array 158 uses beam forming to focus radio waves from f₇ in a desired direction. The antenna array 158 may be used for both transmitting and receiving. On receiving, the antenna array 158 receives an RF signal and sends it to the receiver 154. The number of antennas in the antenna array 158 depends on the desired coverage. The antenna array 158 may include antennas 161, 162, 163, and 164 configured to operate with 5G communication, Gigabit Long Term Evolution (LTE), Wi-Fi (e.g., 2.4 GHz, 5 GHz, and 6Ghz), and Bluetooth, respectively. The number of antennas may be more or less than the above.

The VCO 156 couples multiple in-phase oscillators together to provide low phase noise oscillation. It generates signals vₜ and vᵣ to the mixers at specified frequencies. It may include multiple oscillation core circuits (or VCO cores) to provide high-frequency periodic signals.

The receiver 154 processes the received signal r₇ in a manner reverse from the transmitter 152. It may include a low noise amplifier (LNA), an RF circuit, a mixer, an IF circuit, an AGC, and an analog-to-digital converter (ADC). The receiver 154 may include more or less than the above components. The LNA amplifies the weak signal r₇ while maintaining a good signal-to-noise ratio (SNR) to produce a signal r₆ for further processing. The signal r₆ is next processed by the RF circuit such as band-pass filtering to provide a signal r₅. Additional filtering may be performed in the next stages. The signal r₅ is then mixed with the signal vᵣ from the VCO 156 to down convert the signal r₅ to a signal r₄ at an appropriate low frequency. Like the mixer in the transmitter 152 but with a reverse operation, the mixer in the receiver performs frequency modulation to translate the high frequency signal r₅ to a low frequency signal r₄. The signal r₄ goes through IF processing such as additional filtering by the IF circuit to produce a signal r₃. The AGC amplifies and strengthens the signal and generates a signal r₂. The ADC converts the analog signal r₂ into digital data r₁ which will be processed by the CPU 110.

The analog baseband circuit 170 provides analog processing for various components. It handles processing of signals and data between the digital baseband circuit and the RF transceiver circuit 150. It may include analog and digital components to perform various tasks including modulation/demodulation, controlling the RF transceiver circuit 150, special circuitry for 3G, 4G/LTE, Bluetooth, and 5G communication. It may also interface with an audio device circuit 174, a sensor circuit 176, a Subscriber Identity Module (SIM) card 178, and other components. The audio device circuit 174 may include operational blocks to process audio signals and perform audio-related functions such as filtering, correlation, speech recognition. It may include digital circuits to perform Fast Fourier Transform (FFT) to perform signal processing in the frequency domain. The sensor circuit 176 may include a variety of sensors such as proximity, ambient light, motion (accelerometer and gyroscope, compass, barometer, fingerprint sensor for touch identification (ID), image sensors for face ID, light detection and ranging (LiDAR) scanner, etc. The SIM card 178 is a small, removable chip that stores the user's phone number and carrier information, allowing the device to connect to a cellular network.

The power supply and battery circuit 180 provides power and battery backup supply to the entire system. It may include a charger to charge the battery. The battery may be a rechargeable battery, of Lithium-Ion battery. Power management may be performed by application software and circuits to provide low power mode and performance management.

The system 100 is an example that illustrates the role of 3D memory devices in a laptop, desktop or mobile environment. In many cases, the environment of the applications adds additional requirements including low power consumption, reliable signal integrity, fault-tolerance, and reliable operations in extreme conditions including heat and tight space. Examples of other applications that would benefit from 3D memory devices or circuits include mobile communication (e.g., smart phones, base stations, user equipment), cameras, vehicles, entertainment (e.g., games, multimedia, music, movies), technical designs (e.g., animation, graphics), medical (e.g., visualization, medical imaging), robotics, drones, automatic test equipment, audio processing, speech synthesizer, video and image analysis, vision, automatic face recognition, artificial intelligence (AI) applications, and data centers.

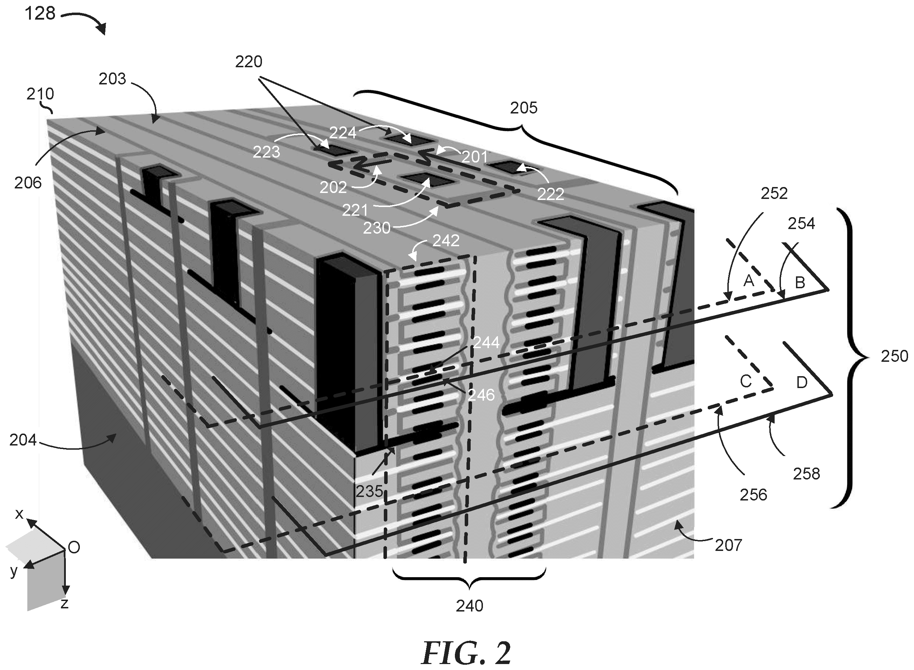

FIG. 2 is a diagram illustrating the 3D memory circuit 128, shown in FIG. 1, that utilizes a blocking structure to prevent contact shorting during an etching process according to an embodiment. The memory circuit 128 include a 3D semiconductor block or structure 210. The structure 210 represents a 3D memory device or circuit. Its geometry is characterized by a 3D coordinate system (Ox, Oy, and Oz) with a center O. The axes Ox and Oy defines horizontal directions when positioned on a ground surface. The axis Oz defines a vertical direction. In one embodiment, the axes Ox and Oy are orthogonal and defines a horizontal surface 203. The axes (Ox. Oz) and (Oy, Oz) define vertical surfaces 204 and 207, respectively, that are orthogonal to the horizontal surface 203.

For illustrative purposes, not all components are shown. The top surface 203 shows the lay out of the contacts, the associated blocking structures, and various elements of the 3D memory circuit. The structure 210 includes a pad area or region 205 and an array area or region 240. The pad area 205 is the area where contacts with word lines are located. The array area 240 is the area that includes word lines (WLs) and other elements of the memory circuit such as capacitors for storage, sense amplifiers, etc. In some embodiments, these contacts are staircase-free contacts. The pad area 205 includes contacts 220 and a blocking structure 230. For illustrative purposes, only four contacts are shown including contacts 221, 222, 223, and 224. These contacts have a 3D shape and are shown to have a rectangular or square shape at a cross-sectional view on the top surface 203. They extend vertically downward in a vertical direction Oz. The blocking structure 230 also has a 3D shape and encloses or extends around the contact 221 from top to bottom in the 3D structure 210. The blocking structure 230 extends around contact 221 in a first direction 201 parallel to the Ox direction and a second direction 202 parallel to the Oy direction. A trench line 206 running in the first direction 201 is part of what is referred to as an isolation (ISO) module used in an ISO process. On the other hand, the contacts 221 and 222 are arranged in the 202 direction and are formed in what is referred to as deep trench isolation (DTI) module used in a DTI process

The array area 240 includes a set 242 of tiered WLs. The set 242 includes an array of elements that form the WLs and capacitors including silicon layers 244 and metal layers 246. The set 242 includes a contact point 235 where a contact pillar contacts a WL. The contacts and the corresponding blocking structures can be seen at various views seen from the top on different cross-sectional surfaces. For illustrative purposes, a set 250 of four cross-sectional views is shown. These views are shown on surfaces that are parallel to the top surface 203. These surfaces include views 252, 254, 256, and 258. The view 252 represents surface A that cuts through the silicon layer 244 above the contact point 235. The view 254 represents surface B that cuts through the oxide layer 246 above the contact point 235. The view 256 represents surface C that cuts through a silicon layer below the contact point 235. The view 258 represents surface D that cuts through a metal layer below the contact point 235.

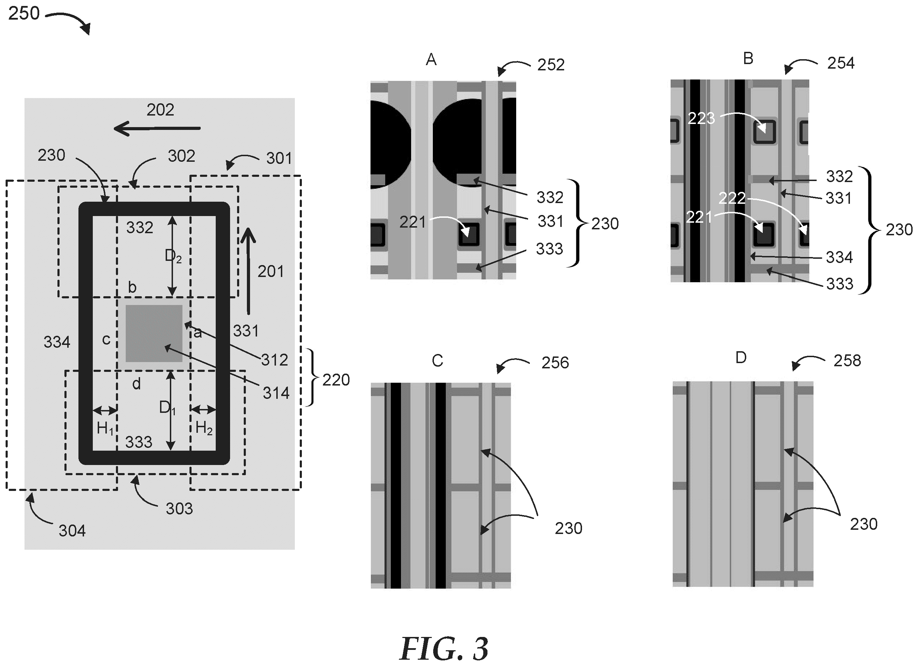

The cross-sectional views of the contacts and the blocking structure will be shown and further described in FIG. 3. In the following, dielectric materials may be deposited as layers to perform insulating, protecting, or blocking functions. In some embodiments, there are two types of dielectric. The first and second dielectrics. The first dielectric performs the normal insulating function while the second dielectric performs blocking functions such as stopping etching. In some embodiments, the second dielectric has higher resistance to chemical etching than the first dielectric, and is therefore suitable to be used as the material for the blocking structure 230. In some embodiments, the second dielectric has higher thermal and mechanical stability than the first dielectric. In some embodiments, the first dielectric comprises an oxide including silicon oxide (SiO₂), titanium dioxide (TiO₂), and iridium oxide (IrOₓ) and the second dielectric comprises a nitride including silicon nitride (Si₃N₄), gallium nitride (GaN), aluminum gallium nitride (AlGaN), hexagonal boron nitride (h-BN), and aluminum nitride (AIN). In the following, for illustrative purposes, oxide and silicon nitride may be referred to, but any other suitable dielectric materials may be used.

FIG. 3 is a diagram illustrating top views 250 of the blocking structure at various depth levels according to an embodiment. The views 250 include views 252, 254, 256, and 258, the contact 220 and the blocking structure 230.

The contact 220 includes a conductive or metal area 312 enclosed by a dielectric layer 312. The blocking structure 230 may surround or enclose the contact 220 depending on the depth level or the position of the surface relative to the vertical direction. The illustrative figure shows the blocking structure 230 enclosing or extending around the contact 220.

The views 252 and 254 show the blocking structure 230 and contacts 221 and 222. The view 252 corresponds to a virtual plane through a silicon layer of a WL such as the layer 244 in FIG. 2. The view 254 corresponds to a virtual plane through an oxide layer of a WL such as the layer 246 in FIG. 2. The contacts 221 and 222 are collectively represented by the contact 220. The contacts 221 and 222 contact or are connected to word lines (WLs) in the pad area 205. The geometry of the blocking structure 230 with respect to the contact 220 may be described in terms of regions 301, 302, 303, and 304. The blocking structure 230 includes four blocking members 331, 332, 333, and 334. The four blocking members are walls that extend from the top surface to the bottom or base surface. When viewed in a sectional view on a surface, the blocking structure 230 assumes a two-dimensional geometrical shape such as a square or rectangle and the four blocking members 331, 332, 333, and 334 are line segments. In the following, while the description refers to the 2D shapes, it is extended to 3D shapes.

The blocking member 331 is positioned between the contacts 221 and 222. The contact 221 is represented by the contact 220. It has four sides a, b, c, and d. The blocking member 331 is positioned between the contacts 221 and 222 along a direction 201 in the region 301 on the first side a. The blocking member 332 is connected to the blocking member 331 along a direction 202 and is positioned in the region 302 on the side b. The blocking member 333 is connected to the blocking member 331 along a third direction and positioned in the region 303 on the side d. The blocking member 334 is connected to the blocking members 332 and 333 and is positioned in the region 304 on the side c.

When all four blocking members are present, they form a structure that encloses the contact 220 or extends, runs, is disposed, is placed, or is arranged alongside the four sides of the contact 220. When only three blocking members are present, they form a structure that extends, runs, or is disposed, placed, or arranged alongside the corresponding sides of the contact 220. Typically, the blocking structure are separated from the sides of the contact 220 by a distance. This distance may be fixed or variable. For example, when only blocking members 331, 332, and 333 are present, the blocking structure 230 extends alongside the sides a, b, and d of the contact 220.

The view 252 shows the surface A. The surface A is orthogonal to the silicon layer 244. In this view, the contact 221 is visible because the surface A is above the contact point 235 and the view is seen from the top. The blocking structure 230 includes only three blocking members 331, 332, and 333 because the cut is along the silicon layer 244 (shown in FIG. 2). The three blocking members 331, 332, and 333 are disposed on a virtual plane corresponding to the surface A through the silicon layer 244. The view 254 shows the surface B. The surface B is orthogonal to the oxide layer 2446. In this view, the contact 221 is visible because the surface B is above the contact point 235 and the view is seen from the top. The blocking structure 230 includes all four blocking members 331, 332, 333, and 334 because the cut is along the oxide layer 244 (shown in FIG. 2). The four blocking members 331, 332, 333, and 334 are disposed on a virtual plane corresponding to the surface B through the oxide layer 246. The view 256 shows the surface C. In this view, the contact 221 is not visible because the surface C is below the contact point 235 and the view is seen from the top. The blocking structure 230 is visible including all four blocking members, showing that the blocking structure 230 extends from top to bottom. The view 258 shows the surface D. In this view, the contact 221 is not visible because the surface D is below the contact point 235 and the view is seen from the top. The blocking structure 230 is visible including all four blocking members, showing that the blocking structure 230 extends from top to bottom.

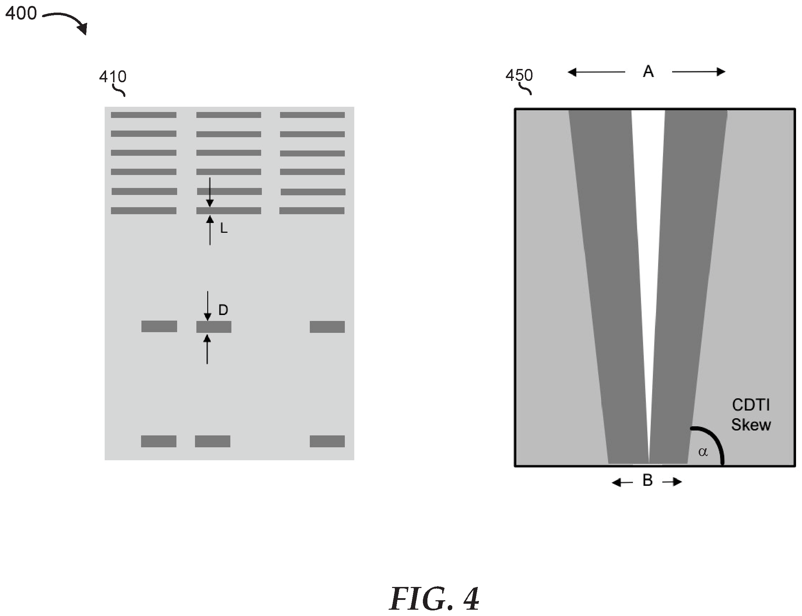

FIG. 4 is a diagram illustrating a geometry 400 showing dimensions and geometrical properties of some elements in the memory circuit according to an embodiment. The geometry 400 includes views 410 and 450. The view 410 shows the array and the pad regions.

The view 410 shows the dimension L of the WLs and dimension D of the trench for the blocking structure as seen from the top. In one embodiment, L = 35 nm and D = 58.4 nm. The WLs belong to the array region and the blocking structure belongs to the pad region.

The view 450 shows a side view of the trench. It has a dimension A at the top and a dimension B at the bottom or the base. The difference in length of A and B illustrates the bowing effect which create a skew angle a from a deep trench isolation (DTI) etching process. In one embodiment, A = 58.4 nm and B = 45 nm.

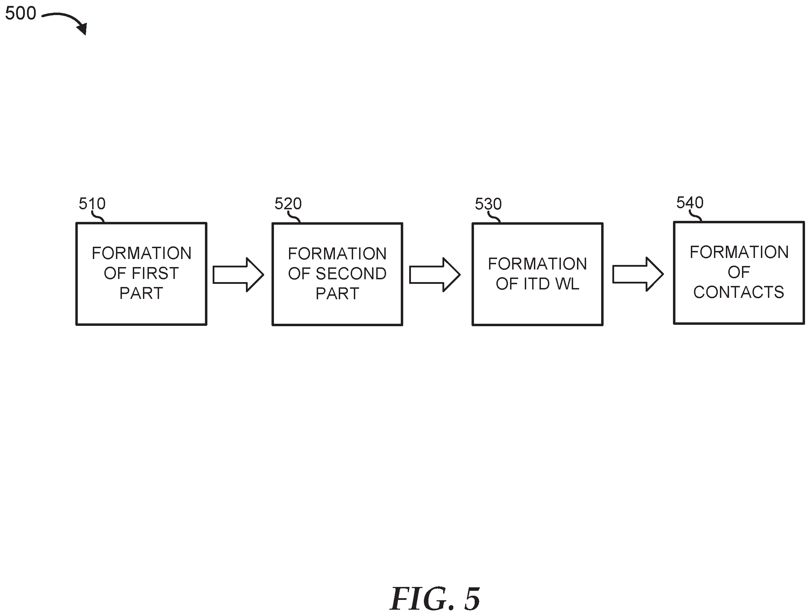

FIG. 5 is a diagram illustrating a process 500 that forms the blocking structure according to an embodiment. The process 500 includes processes or stages 510, 520, 530, and 540. The process 500 may include more or fewer than the above processes or stages. The process 500 represents the fabrication stages of forming the blocking structure during the manufacturing of the memory circuit.

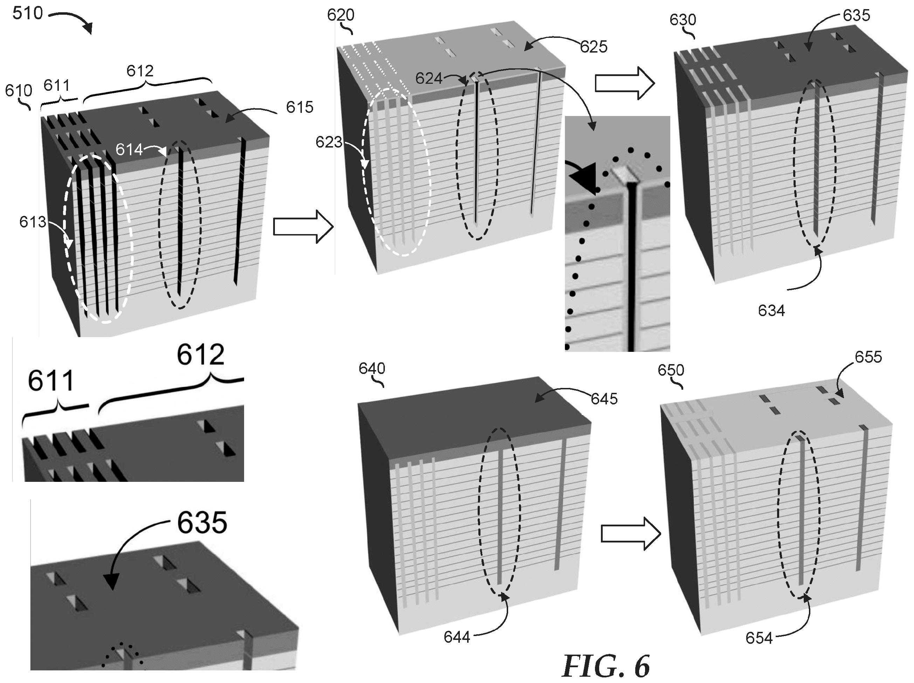

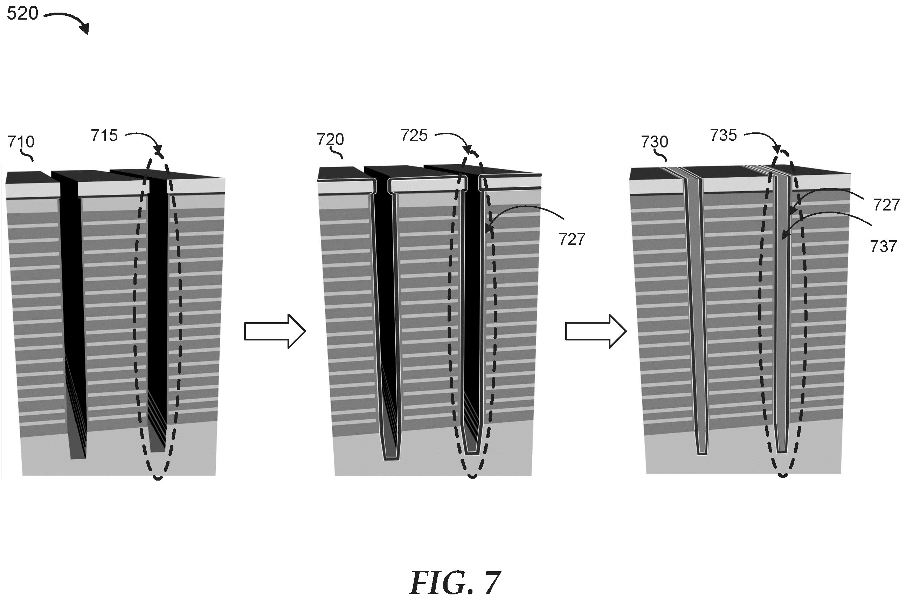

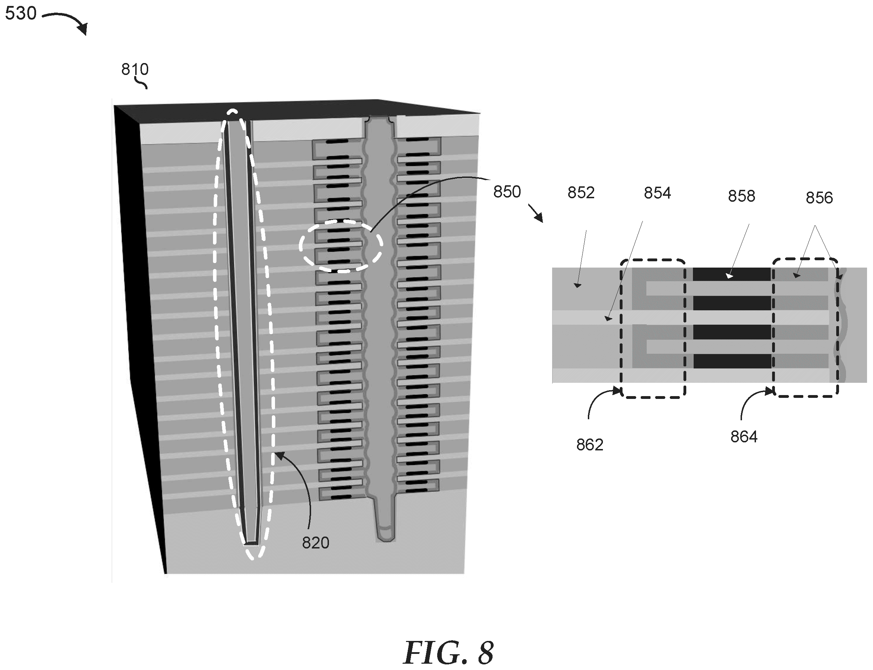

The process 510 forms a first part of the blocking structure in a first module of the 3D base structure. The process 510 will be further described in FIG. 6. The process 520 forms a second part of the blocking structure in a second module along the first module. The process 520 will be further described in FIG. 7. The process 530 forms inter-tier dielectric (ITD) word lines (WL) in the second module. The process 530 will be further described in FIG. 8. The process 530 forms inter-tier dielectric (ITD) word lines (WL) in the second module. The process 530 will be further described in FIG. 8.

FIG. 6 is a diagram illustrating the process 510, shown in FIG. 5, of forming a first part of the blocking structure according to an embodiment. The process 510 includes structures 610, 620, 630, 640, and 650. The process 510 may include more or fewer than the above structures. The diagram also includes insets which show enlarged views of the referenced parts.

The structure 610 includes an array area or region 611 and a pad area or region 612. The array area 611 and the pad area 612 correspond to the array area 240 and the pad area 205 shown in FIG. 2. The structure 610 is formed by a process called deep trench isolation (DTI) which is a process to etch trenches for forming components in subsequent stages. The DTI process is performed mainly in a module referred to as a DTI module which corresponds to the pad area 612. The trenches for the array area 611 have a width L smaller than the width D of those in the pad area 612 as shown in FIG. 4. The top surface is a cap layer 615 and includes a silicon nitride layer and show the trench structures. The inset shows an enlarged view of the areas 611 and 612.

The structure 620 is formed from the structure 610 by depositing an oxide liner into the etched structure 610 to form a liner trenches 623 and 624. Because the array trenches are narrower than the pad trenches, the trench 623 in the array area 611 is filled with oxide while the trench 624 is not fully filled with oxide and leave a gap in the trench as shown in the inset. In one embodiment, the oxide liner is about 20 nm and the trench 624 is about 56.4 nm. Therefore, the oxide liner does not fill the trench 624 completely and there is a gap or void along the trench.

The structure 630 is formed from the structure 620 by trimming or cleaning the oxide liner in the liner trenches in both the array area 611 and the pad area 612 to form trimmed liner trenches including a trimmed liner trench 634 in the pad area. For the array area 611, the etching is done at the top only. For the pad area 612, the cleaning still leaves the trench 634 open. The DTI module has a stop surface 635. The top surface 635 is shown in an enlarged view in the inset.

The structure 640 is formed from the structure 630 by depositing silicon nitride into the trimmed liner trench 644. The result is a cap layer 645 at a top surface and a trench 644 filled with silicon nitride. The trenches in the array area 611 remain filled with oxide, but they can be filled with other dielectrics such as silicon nitride if desired.

The structure 650 is formed from the structure 640. The trenches in the array area remain filled with oxide and those in the pad area with silicon nitride. The cap layer 645 is removed by a chemical mechanical planarization or polishing (CMP) to become a top surface 655. The trench 644 becomes trench 654 and remained filled with silicon nitride.

FIG. 7 is a diagram illustrating a process 520, shown in FIG. 5, of forming a second part of the blocking structure according to an embodiment. The process 520 includes structures 710, 720, and 730. The process 520 involves an isolation (ISO) etching process along an ISO module next to the DTI module. The process 520 may include more or fewer than the above structures.

The structure 710 is formed by an ISO process that etches long and narrow trenches in the direction 202 (shown in FIG. 2). The trenches are in an ISO module to form etched trenches. The structure 710 includes a representative trench 715 that is formed by the ISO process and a silicon thinning process.

The structure 720 is formed from the structure 710 by depositing a silicon nitride liner into the trench 715 to form a liner trench 725. The trench 725 has a wall 727 as silicon nitride liner that provides blocking function for the blocking structure 230. The structure 730 is formed from the structure 720 by filling an oxide 737 into the liner trench 725 to form a filled liner trench 735. The trench 735 includes the wall 727 and the oxide 737. The structure 730 then goes through a process to form inter-tier dielectric word lines shown FIG. 8.

FIG. 8 is a diagram illustrating the process 530, shown in FIG. 5, of forming inter-tier dielectric word lines according to an embodiment. The process 530 includes a structure 810 and a standard process of creating word lines and capacitor array or storage elements for memory circuits. It includes etching, trimming, and cleaning various layers to form word lines and contact pillars. For illustrative purposes, the structure 810 includes a contact pillar 820 and a representative block 850.

The contact pillar 820 provides a staircase-free contact structure to provide tiered contacts with the WLs. The block 850 includes alternating layers 852, 854, 856, and 858 and groups 862 and 864. These blocks refer to normal layers used in forming WLs and capacitor array. The layer 852 includes oxide. The layer 854 includes silicon. The layer 858 includes metal such as tungsten (W), molybdenum (Mo), tantalum (Ta), used as WL. The layers 856 include silicon nitride or other suitable dielectrics.

The group 862 refers to a lightly doped source (LDS) that functions as first electrode. The group 864 refers to a lightly doped drain (LDD) that functions as a second electrode. The first and second electrodes form a capacitor array that may be used as storage elements of the memory circuits.

The process 530 forms the LDS layer 862 and the LDD layer 864. It etches oxide and polysilicon (OP) layers alternately for the entire module.

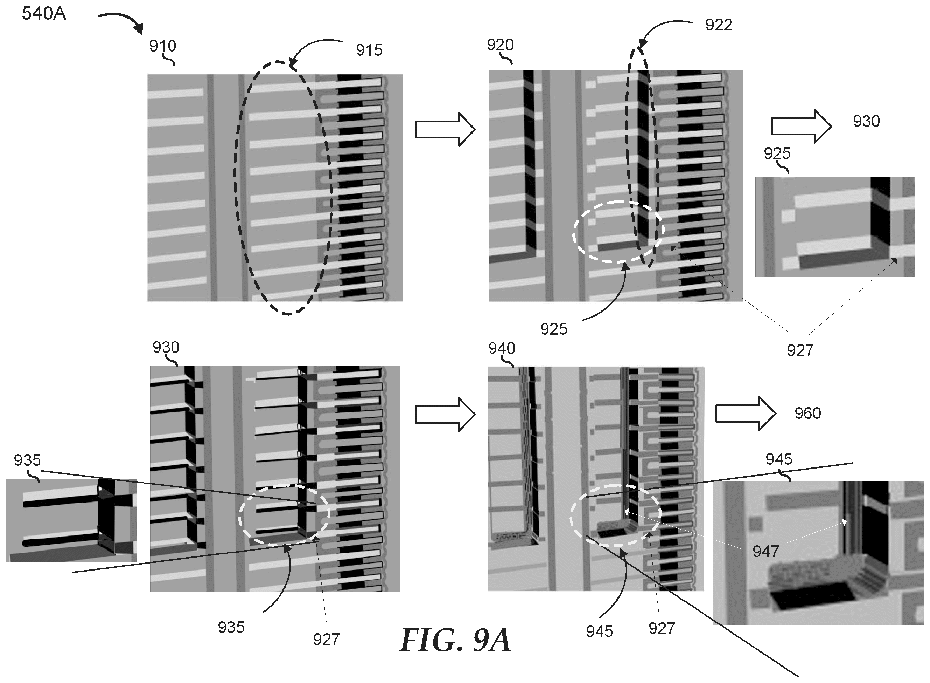

FIG. 9A is a diagram illustrating a first part of a process 540A of forming contacts according to an embodiment. The process 540A includes structures 910, 920, 930, and 940. The process 540A may include more or fewer than the above structures. The insets show enlarged the associated portions of the figures.

The structure 910 is the same as the structure 810 shown in FIG. 8. An area 915 includes alternating oxide (O) layer and polysilicon (P) layer and therefore is referred to as OPOP.

The structure 920 is formed from the structure 910 by performing the staircase-free contact (SFC) OPOP etch to produce an etched area 922. The etched area 922 is a gap that stops at a location 927 on a WL to have a contact. The location 927 corresponds to an end polysilicon layer at a predetermined tier. The etched area 922, therefore, is stopped at location 927.

The structure 930 is formed from the structure 920 by trimming the silicon layers up to the end polysilicon layer at the stop location 927. The etched area 935 shows the silicon is thinned.

The structure 940 is formed from the structure 930 by depositing silicon nitride 947 in the gap up to the end polysilicon layer at the stop location 927 and trimming the stop location 927 in an etched area 945. The silicon nitride 947 protects the WLs above the stop location during the etching to the stop location 927.

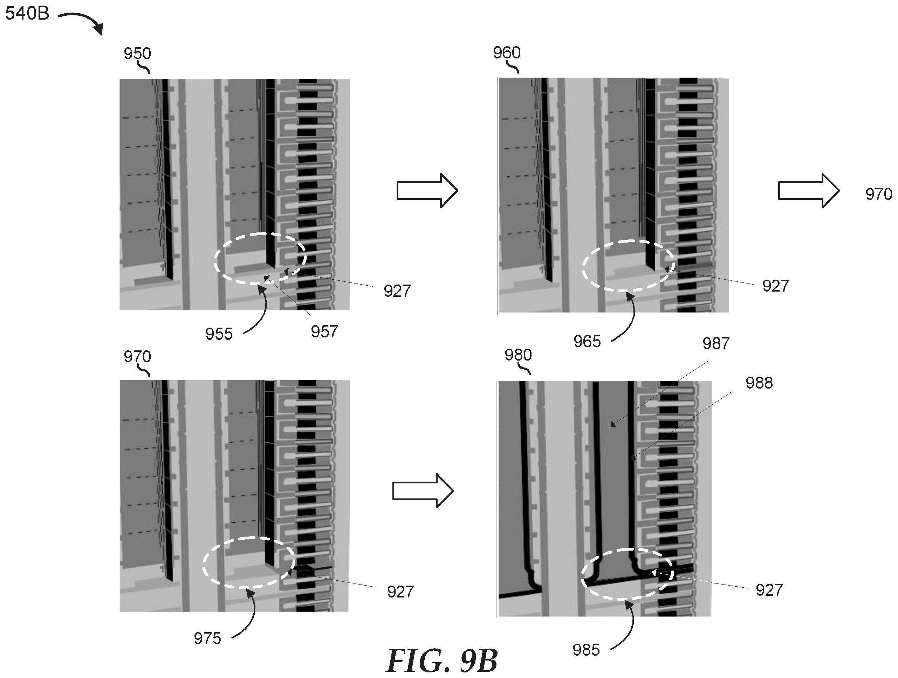

FIG. 9B is a diagram illustrating a second part of a process 540B of forming contacts according to an embodiment. The process 540B includes structures 950, 960, 970, and 980. The process 540B may include more or fewer than the above structures.

The structure 950 is formed from the structure 940 in FIG. 9A by forming a bottom punch 957 in an etched area 955 at the stop location 927. The structure 960 is formed from the structure 950 by trimming silicon layer in an etched area 965 at the stop location 927. The structure 970 is formed from the structure 960 by gate oxide (Gox) cleaning in an etched area 975 at the stop location 927.

. The structure 980 is formed from the structure 970 by depositing tungsten (W) 987 into the contact pillar and titanium nitride (TiN) 988 around the sides. The metal connects to the WL at the stop location 927.

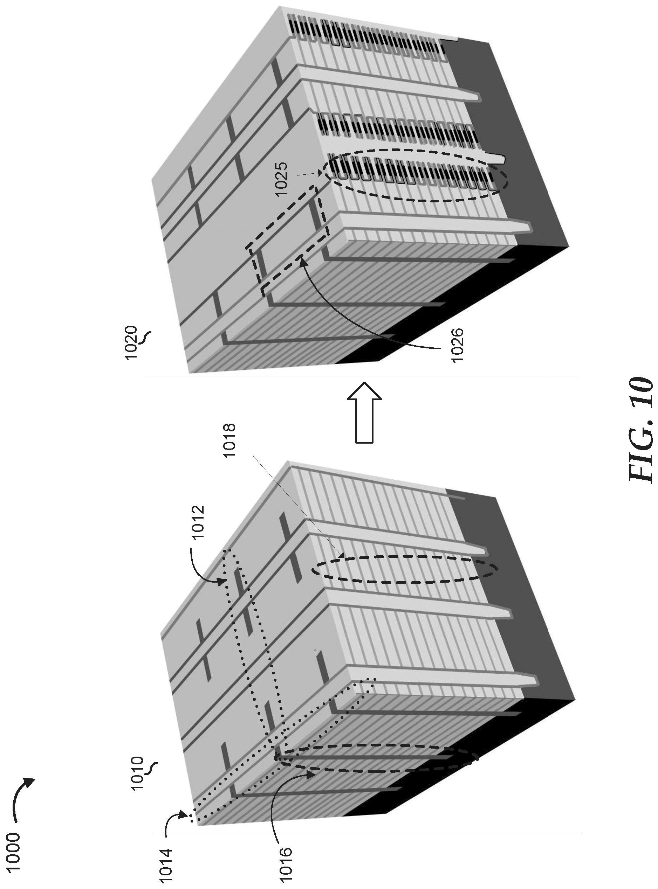

FIG. 10 is a diagram illustrating a result 1000 of the process of forming the blocking structure according to an embodiment. The result 1000 includes structures 1010 and 1020.

The structure 1010 corresponds to a result of the DTI etching and the ISO etching described in FIGS. 6 and 7. A group 1012 shows patterns for blocking members in the second direction 202 in the DTI module. A group 1014 shows patterns for blocking members in the first direction 201 in the ISO module. A group 1016 illustrates the depth of the blocking structure from top to bottom. A group 1018 illustrates patterns for silicon or polysilicon in the array area.

The structure 1020 illustrates the result of the blocking structure and the inter-tier dielectric word lines that corresponds to FIG. 8. The structure 1020 shows a blocking structure 1026 that corresponds to the blocking structure 230 in FIG. 2. A group 1025 shows the ITD WLs that corresponds to FIG. 8.

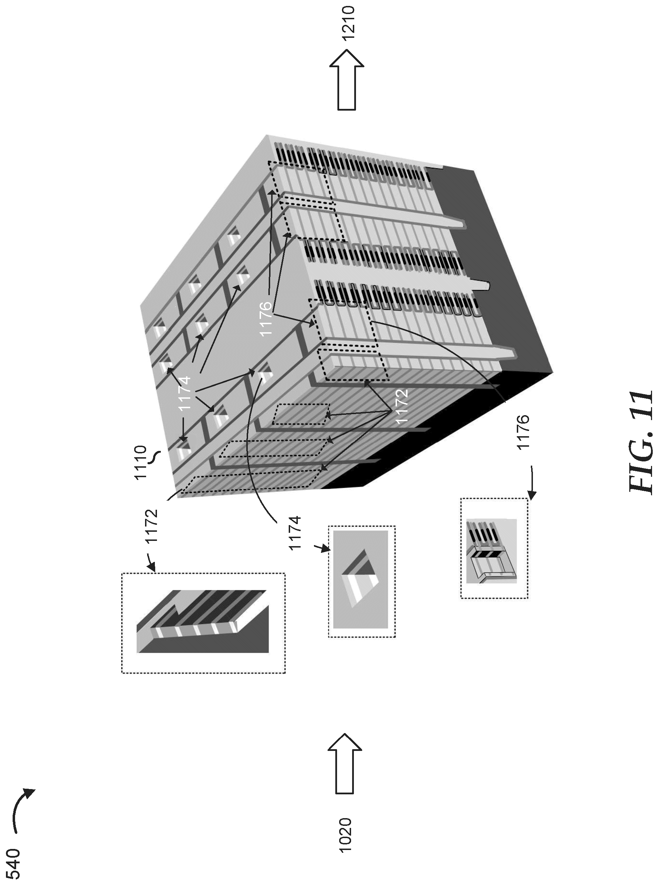

FIG. 11 is a diagram illustrating a result of the process 540 shown in FIGS. 9A and 9B of a partial process of forming the contacts according to an embodiment. The result of the process 540 includes a 3D structure 1110. The structure 1110 shows various components with enlarged parts of the component in the insets.

The top surface of the DTI module shows 3D structures of contacts 1174. The ISO module shows 3D structures 1172. The array area shows the ITD WL groups 1176 that correspond to structure 980 in FIG. 9B.

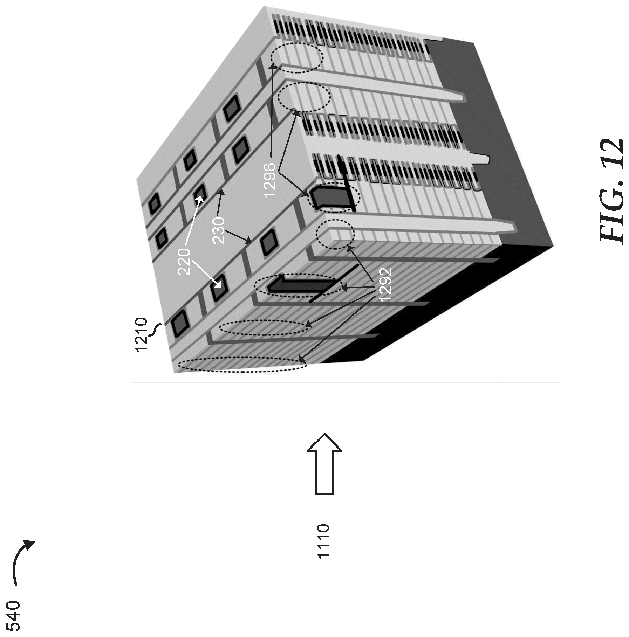

FIG. 12 is a diagram illustrating a result of the process 540 a 3D structure of a final process of forming the contacts according to an embodiment. The final result of the process 540 includes a 3D structure 1210.

The structure 1210 includes the contacts 220 and the blocking structures 230 as seen from a top view which corresponds to FIG. 2. The structure 1210 also includes groups 1292 that illustrate the depths of the contact pillars and groups 1296 that illustrate the completed ITD WLs.

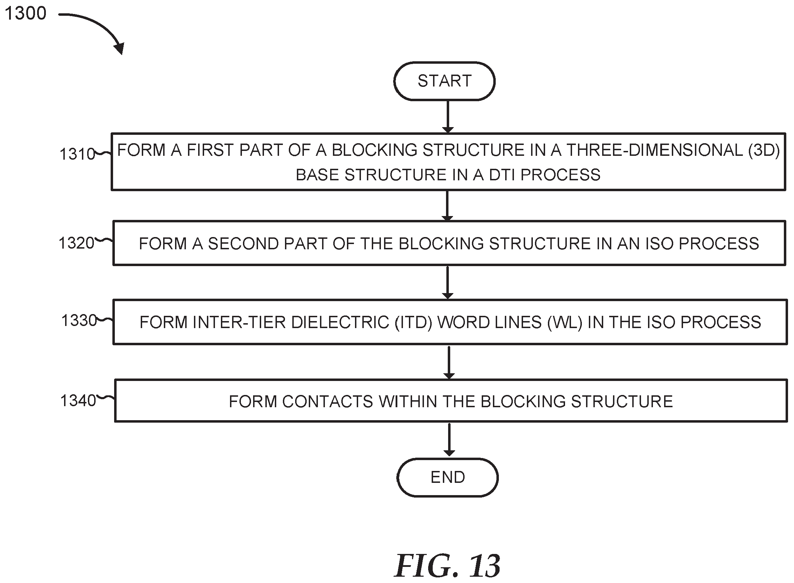

FIG. 13 is a flowchart illustrating a process 1300 of forming a blocking structure that prevents contact shorts according to an embodiment. The process 1300 corresponds to the process 500 in FIG. 5.

The process 1300 forms a first part of a blocking structure in a first module of a three-dimensional (3D) base structure (Process 1310). The base structure corresponds to the structure 610 shown in FIG. 6. The process 1310 corresponds to the process 510 in FIG. 6. The first module refers to the DTI module. Next, the process 1300 forms a second part of the blocking structure in a second module along the first module (Process 1320). The second module refers to the ISO module which is next to the DTI module. The process 1320 corresponds to the process 520 in FIG. 7.

Then, the process 1300 forms inter-tier dielectric (ITD) word lines (WL) in the second module (Process 1330). The process 1330 corresponds to the process 530 in FIG. 8. Next, the process 1300 forms contacts within the blocking structure (Process 1340). The process 1340 corresponds to the process 540 including processes 540A in FIG. 9A and 540B in FIG. 9B.

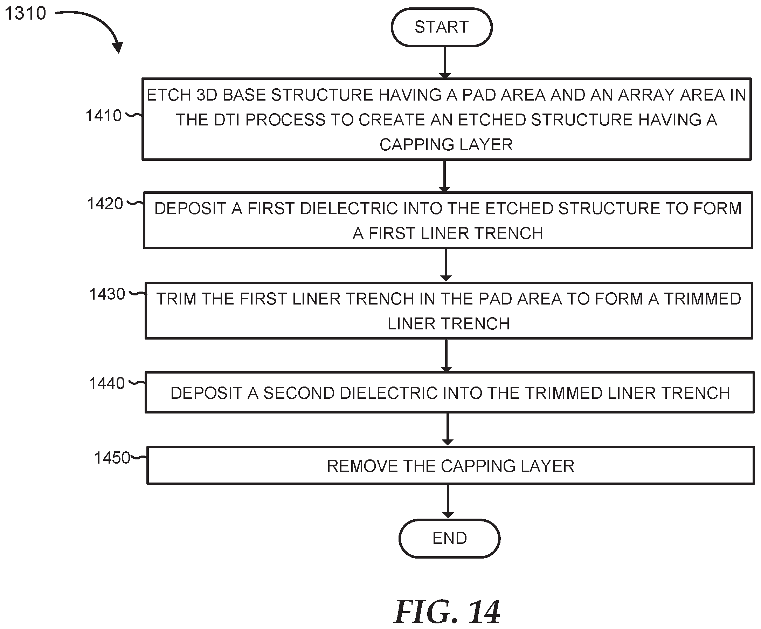

FIG. 14 is a flowchart illustrating the process 1310 shown in FIG. 13 of forming a first part of the blocking structure that prevents contact shorts according to an embodiment. The process 1310 corresponds to the process 510 shown in FIG. 6.

The process 1310 etches the 3D base structure having a pad area and an array area in the first module in a deep trench isolation (DTI) process to create an etched structure having a capping layer (Process 1410). The process 1410 corresponds to the structure 610 in FIG. 6 with the pad area 612 and the array area 611. Next, the process 1310 deposits a first dielectric into the etched structure to form a first liner trench (Process 1420). The first dielectric may include an oxide including silicon oxide (SiO₂), titanium dioxide (TiO₂), and iridium oxide (IrOₓ). The process 1420 corresponds to the structure 620 in FIG. 6.

Then, the process 1310 trims the first liner trench in the pad area to form a trimmed liner trench (Process 1430). The process 1430 corresponds to the structure 630 in FIG. 6. Next, the process 1310 deposits a second dielectric into the trimmed liner trench (Process 1440). In some embodiments, the second dielectric has a property that blocks an etching process to prevent contact shorting. In some embodiments, the second dielectric has higher resistance to chemical etching than the first dielectric. In some embodiments, the second dielectric has higher thermal and mechanical stability than the first dielectric. The second dielectric may include a nitride including silicon nitride (Si₃N₄), gallium nitride (GaN), aluminum gallium nitride (AlGaN), hexagonal boron nitride (h-BN), and aluminum nitride (AIN). The process 1440 corresponds to the structure 640 in FIG. 6 Then, the process 1310 removes the capping layer (Process 1450). The process 1450 corresponds to the structure 650 in FIG. 6.

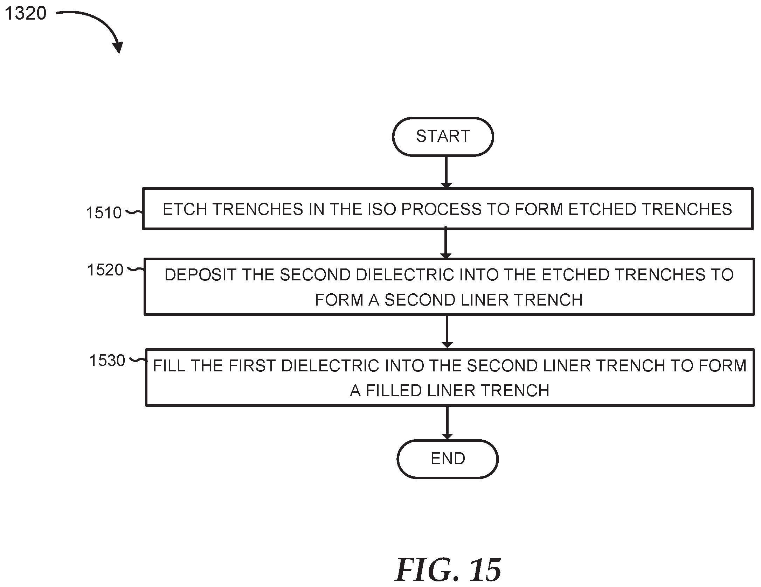

FIG. 15 is a flowchart illustrating the process 1320 shown in FIG. 13 of forming a second part of the blocking structure that prevents contact shorts according to an embodiment. The process 1320 corresponds to the process 520 shown in FIG. 7.

The process 1320 etches trenches in the second module in an isolation (ISO) process to form etched trenches (Process 1510). The process 1510 corresponds to the structure 710 in FIG. 7. Next, the process 1320 deposits the second dielectric into the etched trenches to form a second liner trench (Process 1520). The process 1520 corresponds to the structure 720 in FIG. 7. Then, the process 1320 fills the first dielectric into the second liner trench to form a filled liner trench (Process 1530). The process 1530 corresponds to the structure 723 in FIG. 7.

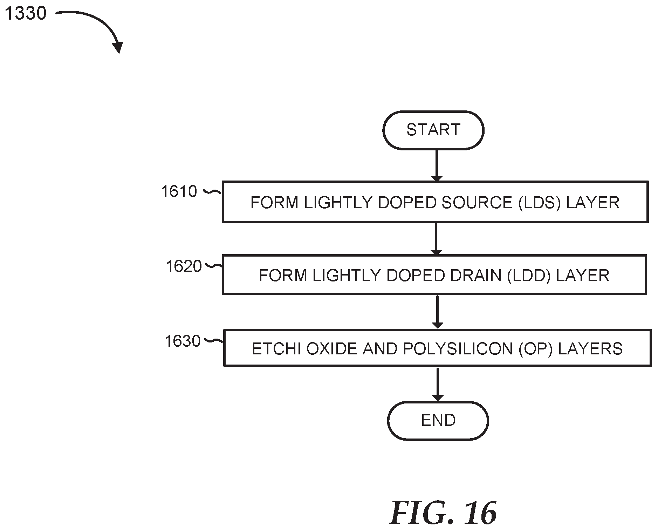

FIG. 16 is a flowchart illustrating the process 1330 shown in FIG. 13 of forming inter-tier dielectric word lines according to an embodiment. The process 1330 corresponds to the process 530 in FIG. 8.

The process 1330 forms lightly doped source (LDS) layer (Process 1610). The process 1610 corresponds to group 862 in the structure 810 in FIG. 8. Next, the process 1330 forms lightly doped drain (LDD) layer (Process 1620). The process 1620 corresponds to group 864 in the structure 810 in FIG. 8. Then, the process 1330 etches oxide and polysilicon (OP) layers (Process 1630). The process 1630 corresponds to layers 852 and 854 in the structure 810 in FIG. 8.

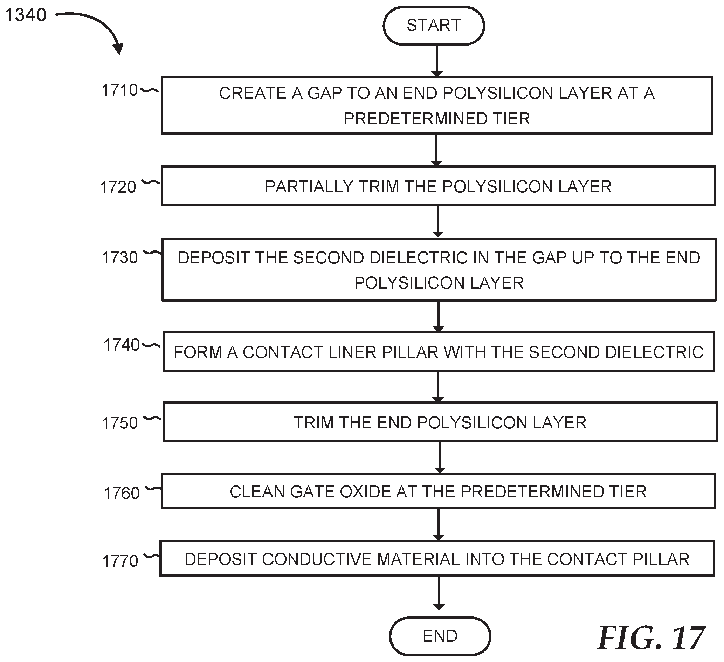

FIG. 17 is a flowchart illustrating the process 1340 in FIG. 13 of forming contacts within the blocking structure according to an embodiment. The process 1340 corresponds to the processes 540A and 540B in FIGS. 9A and 9B.

The process 1340 creates a gap for a contact pillar to an end polysilicon layer at a predetermined tier (Process 1710). The process 1710 corresponds to the structure 920 in FIG. 9A. Next, the process 1340 partially trims the polysilicon layer (Process 1720). The process 1720 corresponds to the structure 930 in FIG. 9A. Then, the process 1340 depositing the second dielectric in the gap up to the end polysilicon layer (Process 1730). The process 1730 corresponds to the structure 940 in FIG. 9A.

Next, the process 1340 forms a contact pillar liner with the second dielectric and a bottom punch (Process 1740). The process 1740 corresponds to the structure 950 in FIG. 9B. Then, the process 1340 trims the end silicon layer (Process 1750). The process 1750 corresponds to the structure 960 in FIG. 9B. Next, the process 1340 cleans gate oxide at the predetermined tier (Process 1760). The process 1760 corresponds to the structure 970 in FIG. 9B. Then, the process 1340 deposits conductive material into the contact pillar (Process 1770). The conductive material may include tungsten (W) and titanium nitride around the sides. The process 1770 corresponds to the structure 980 in FIG. 9B.

While this specification may contain many specific implementation details, the implementation details should not be construed as limitations on the scope of any claimed subject matter, but rather be construed as descriptions of features specific to particular embodiments. Certain features that are described in this specification in the context of separate embodiments may also be implemented in combination in a single embodiment. Conversely, various features that are described in the context of a single embodiment may also be implemented in multiple embodiments separately or in any suitable sub-combination. Moreover, although features may be described above as acting in certain combinations and even initially claimed as such, one or more features from a claimed combination may in some cases be excised from the combination, and the claimed combination may be directed to a sub-combination or variation of a sub-combination.

Similarly, while operations are depicted in the drawings in a particular order, this should not be understood as requiring that such operations be performed in the particular order shown or in sequential order, or that all illustrated operations be performed, to achieve desirable results. In certain circumstances, multitasking and parallel processing may be advantageous. Moreover, the separation of various system components in the embodiments described above should not be understood as requiring such separation in all embodiments, and it should be understood that the described program components and systems can generally be integrated together in a single software product or packaged into multiple software products.

Thus, particular embodiments of the subject matter have been described herein. Other embodiments are within the scope of the following claims. In some cases, the actions set forth in the claims may be performed in a different order and still achieve desirable results. Additionally, the processes depicted in the accompanying figures do not necessarily require the particular order shown, or sequential order, to achieve desirable results. In certain implementations, multitasking and parallel processing may be advantageous.

As will be recognized by those skilled in the art, the innovative concepts described herein may be modified and varied over a wide range of applications. Accordingly, the scope of claimed subject matter should not be limited to any of the specific exemplary teachings discussed above, but is instead defined by the following claims.

## Claims

1. A device comprising:
a first contact having a first side, a second side, and a third side;
a second contact, the first contact and the second contact contacting word lines, WLs, in a pad area of a three-dimensional memory device;
a first blocking member positioned between the first contact and the second contact along a first direction in a first region on the first side;
a second blocking member connected to the first blocking member along a second direction and positioned in a second region on the second side; and
a third blocking member connected to the first blocking member along a third direction and positioned in a third region on the third side,
wherein the first blocking member, the second blocking member, and the third blocking member form a structure that extends around the first side, the second side, and the third side, respectively, the structure blocking an etching process.

2. The device of claim 1, wherein the first blocking member, the second blocking member, and the third blocking member extend in a depth direction that is orthogonal to a plane defined by the first direction and the second direction.

3. The device of claim 1 or 2, wherein at least one of the first contact and the second contact comprises a staircase free contact.

4. The device of any one of claims 1 to 3, wherein the first blocking member, the second blocking member, and the third blocking member are disposed on a virtual plane through a silicon layer in one of the WLs.

5. The device of any one of claims 1 to 4, further comprising:
a fourth blocking member connected to the second and third blocking members and positioned in a fourth region on a fourth side of the first contact,
wherein the structure further includes the fourth blocking member and encloses the first contact.

6. The device of claim 5, wherein at least one of the first blocking member, the second blocking member, the third blocking member, and the fourth blocking member comprises a material that blocks an etching process.

7. The device of claim 5 or 6, wherein the first blocking member, the second blocking member, the third blocking member, and the fourth blocking member are disposed on a virtual plane through an oxide layer in one of the WLs.

8. The device of claim 7, wherein the material comprises a nitride including at least one of silicon nitride, Si₃N₄, gallium nitride, GaN, aluminum gallium nitride, AlGaN, hexagonal boron nitride, h-BN, or aluminum nitride, AIN.

9. The device of any one of claims 1 to 8, wherein the first direction is orthogonal to the second direction.

10. The device of any one of claims 1 to 9, wherein, the first direction is orthogonal to the third direction.

11. A method comprising:
forming a first part of a blocking structure in a three-dimensional, 3D, base structure in a deep trench isolation, DTI. process;
forming a second part of the blocking structure in an isolation, ISO process;
forming inter-tier dielectric, ITD, word lines, WL, in the ISO process; and
forming contacts within the blocking structure.

12. The method of claim 11, wherein forming the first part comprises:
etching the 3D base structure having a pad area and an array area in the DTI process to create an etched structure having a capping layer;
depositing a first dielectric into the etched structure to form a first liner trench;
trimming the first liner trench in the pad area to form a trimmed liner trench;
depositing a second dielectric into the trimmed liner trench; and
removing the capping layer.

13. The method of claim 11 or 12, wherein forming the second part comprises:
etching trenches in the ISO process to form etched trenches;
depositing the second dielectric into the etched trenches to form a second liner trench; and
filling the first dielectric into the second liner trench to form a filled liner trench.

14. The method of any one of claims 11 to 13, wherein forming ITD WL comprises:
forming lightly doped source, LDS, layer;
forming lightly doped drain, LDD, layer; and
etching oxide and polysilicon, OP, layers.

15. The method of claim 14, wherein forming the contacts comprises:
creating a gap for a contact pillar to an end polysilicon layer at a predetermined tier;
trimming silicon layers up to the end polysilicon layer;
depositing the second dielectric in the gap up to the end polysilicon layer
forming a contact pillar liner with the second dielectric and a bottom punch;
trimming the end silicon layer;
cleaning gate oxide at the predetermined tier; and
depositing conductive material into the contact pillar.
